# DEMANDE DE BREVET EUROPEEN

(11) **EP 3 726 556 A1**
(43) Date de publication de la demande: **21.10.2020**
(21) Numéro de dépôt: 20168109.5
(22) Date de dépôt: 03.04.2020
(51) Int. Cl.: H01H 37/76, H01L 23/525, H01L 23/62, H05K 1/02

(54) **DISPOSITIF DE COMMANDE SECURISÉ POUR ACTIONNEUR ELECTRIQUE**

(30) Priorité: 16.04.2019 FR 1904021
(71) Demandeur: G. Cartier Technologies, 74302 Cluses (FR)
(72) Inventeur: PIGNAL-JACQUARD, Marcel, 74890 BONS EN CHABLAIS (FR); BREHERET, Jean-Luc, 74300 CHATILLON SUR CLUSES (FR)
(74) Mandataire: Cabinet Poncet

(57) **Abrégé**

Dispositif de commande à découpage de tension à modulation de largeur pour un actionneur électrique (2) tel qu'un moteur, comprenant au moins un circuit électronique de puissance (3) avec un premier transistor (6) à effet de champ à grille isolée connecté électriquement par des premiers moyens de connexion (11a) à un conducteur de sortie (7) alimentant l'actionneur électrique (2). Les premiers moyens de connexion (11a) comprennent une première brasure et des premiers moyens de couplage thermique par conduction (13) entre la première brasure et le corps du premier transistor (6) à effet de champ à grille isolée. Ladite première brasure est agencée de telle sorte que, lorsque le corps du premier transistor (6) à effet de champ à grille isolée dépasse un seuil de température prédéterminé, la première brasure fond et interrompt la connexion électrique entre le premier transistor (6) à effet de champ à grille isolée et l'actionneur électrique (2).

## Description

### DOMAINE TECHNIQUE DE L'INVENTION

La présente invention concerne les dispositifs de commande permettant de commander la vitesse de déplacement d'un actionneur électrique, et notamment la vitesse de rotation d'un moteur électrique à courant continu servant à la ventilation des échangeurs et du moteur d'un véhicule automobile, pour leur refroidissement.

Dans un véhicule automobile, l'échangeur thermique associé au refroidissement de l'eau servant au transfert des calories générées par le moteur thermique est généralement couplé, par mise en série dans un même flux d'air de refroidissement, avec l'échangeur servant à l'évacuation des calories issues de la compression du gaz utilisé pour la climatisation. Un ventilateur, entraîné en rotation par un moteur à courant continu, est placé devant ou derrière ces échangeurs afin de générer le flux d'air de refroidissement devant les traverser pour faciliter les échanges thermiques. Ce flux d'air de refroidissement est ensuite dirigé vers le moteur du véhicule.

Les besoins en débit d'air associés à ce couple « échangeur de refroidissement moteur - échangeur de climatisation » peuvent aller :
- d'une ventilation douce, dans le cas d'une température basse du moteur du véhicule et d'une demande modérée de la climatisation alors que le véhicule est roulant et que sa vitesse de déplacement génère déjà ainsi un flux d'air,
- à une ventilation maximale, dans le cas d'un véhicule à l'arrêt avec moteur du véhicule en surchauffe après une longue montée avec véhicule chargé, couplé à une forte température externe générant un besoin en climatisation important.

Cette différence de besoins est traitée dans la plupart des cas par des vitesses variables du ventilateur réalisées par un dispositif de commande générant une tension variable sur les bornes d'alimentation du moteur à courant continu.

Un premier type connu de dispositif de commande à tension variable utilise une résistance en série dans le circuit d'alimentation de l'actionneur électrique de type moteur à courant continu, produisant la réduction du courant et de la tension aux bornes du moteur électrique, pour une rotation à vitesse réduite. Pour produire une rotation à vitesse maximale du moteur électrique, cette résistance est court-circuitée. Ce type de dispositif de commande à résistance série est décrit par exemple dans le document FR 2 826 199 A1.

Un second type connu de dispositif de commande à tension variable utilise un dispositif électronique de découpage de tension à modulation de largeur, généralement désigné par le sigle PWM (pulse width modulation - modulateur de largeur d'impulsion), produisant une tension de sortie qui est tantôt égale à la tension d'entrée pendant des étapes de conduction, tantôt égale à zéro pendant des étapes de non-conduction, et dont on fait varier la valeur moyenne par la modification du rapport des durées des étapes de conduction et des étapes de non-conduction. On peut ainsi moduler la vitesse de rotation du moteur électrique de façon plus fine et progressive que dans la technologie à résistance série. Ce type de dispositif électronique de commande à modulation de largeur est décrit par exemple dans le document US 6,369,533 B1.

Les constructeurs automobiles recherchent actuellement l'augmentation de la durée de vie des véhicules, la réduction des pertes électriques (réduction de la consommation en carburant, ou augmentation de l'autonomie pour les véhicules électriques), la modération du coût de production et la diminution du bruit.

La technologie à résistance série, particulièrement performante d'un point de vue économique, peine à rester compatible avec l'augmentation de la durée de vie des véhicules car, presque exclusivement basée sur des relais électromécaniques, son nombre de commutations avant défaut est limité. Son plus gros désavantage réside dans les pertes d'énergie électrique générées par la résistance série. En effet, celles-ci atteignent couramment 100% de l'énergie nécessaire à la ventilation au point de fonctionnement le plus utilisé.

La technologie à découpage de tension à modulation de largeur PWM semble être une solution plus avantageuse, malgré un coût largement supérieur à celui de la technologie à résistance série. Dans ce cas, pour réaliser les étapes de conduction et les étapes de non-conduction, la commutation du courant électrique d'alimentation du moteur à courant continu est assurée par un circuit électronique de puissance comportant des composants électroniques de type transistor à effet de champ à grille isolée (MOSFET), et des diodes de puissance. Pendant leur fonctionnement, ces composants électroniques subissent un échauffement non négligeable, la température de leur jonction pouvant avoisiner les 150°C ou 175°C, sans toutefois que cela ne perturbe leur fonctionnement. La durée de vie de ces composants électroniques est très largement supérieure à celle d'un système à relais. Toutefois, du fait du dimensionnement des moteurs revu à la baisse pour des questions d'écologie, les moteurs des véhicules automobiles d'aujourd'hui ont tendance à fonctionner dans des atmosphères de plus en plus chaudes et dans des espaces de plus en plus confinés (notamment dans le cas des véhicules hybrides). Cette élévation de température diminue la durée de vie des composants électroniques, notamment ceux de type transistor à effet de champ à grille isolée (MOSFET). Et au-delà de certaines températures, il peut se produire une défaillance des composants électroniques de type transistor à effet de champ à grille isolée (MOSFET), pouvant mener à des risques d'incendie du véhicule.

Des surtensions du réseau d'alimentation du véhicule peuvent également endommager les transistors à effet de champ à grille isolée (MOSFET). Ces derniers sont en outre facilement endommagés par des erreurs de manipulations commises lors de leur assemblage dans un circuit électrique. Il y a également des risques de défaillance d'un transistor à effet de champ à grille isolée (MOSFET) résultant de sa mauvaise fabrication.

Le document DE 10 2010 003241 A1 décrit un onduleur triphasé comprenant des commutateurs de puissance pour l'alimentation du moteur électrique sans balais d'un dispositif de direction automobile électromécanique. Pour éviter la détérioration des commutateurs de puissance en cas de surcharge ou de défaut, le document enseigne de prévoir au moins un interrupteur de sécurité, connecté en série entre la source d'alimentation et l'entrée de l'onduleur, et dont l'ouverture est commandée par un circuit de détection de défaut ou de surcharge. L'interrupteur de sécurité comprend un conducteur élastique dont une extrémité est retenue par une brasure destinée à fondre en cas d'élévation de température provoquée par une source de chaleur commandée par le circuit de détection de défaut ou de surcharge Les figures montrent la source de chaleur et la brasure disposées à faible distance l'une de l'autre sur des pistes conductrices respectives prévues sur un substrat isolant de circuit imprimé. Aucune information n'est donnée sur d'éventuelles propriétés particulières du substrat isolant de circuit imprimé, ni sur son utilisation éventuelle pour conduire la chaleur entre la source de chaleur et la brasure.

Le document US 2012/268854 A1 décrit un composant électronique muni d'un dispositif de protection intégrée qui interrompt le passage du courant électrique dans le composant en cas de surchauffe du composant. Le dispositif de protection est formé par l'un des conducteurs de puissance du composant, présentant une contrainte élastique, et dont une extrémité est fixée à une piste conductrice par une brasure susceptible de fondre et d'ouvrir le circuit en cas d'élévation de température due à un échauffement du composant ou à un échauffement venu de l'extérieur. Le composant et la brasure sont disposés sur des pistes conductrices respectives prévues sur un substrat isolant de circuit imprimé. Aucune information n'est donnée sur d'éventuelles propriétés particulières du substrat isolant de circuit imprimé, ni sur son utilisation éventuelle pour conduire la chaleur entre le composant et la brasure.

Le document US 2011/211284 A1 décrit un élément de protection comprenant, entre deux bornes principales, un circuit de puissance comportant un conducteur élastique précontraint qui relie l'une à l'autre, par deux soudures fusibles, deux pistes conductrices connectées respectivement aux deux bornes principales. Une résistance électrique, alimentée par un circuit de commande externe, permet d'échauffer et de fondre les soudures fusibles pour ouvrir ainsi le circuit de puissance entre les deux bornes principales. Une couche isolante (14) est disposée entre la résistance électrique et lesdites piste conductrices. Aucune information n'est donnée sur d'éventuelles propriétés particulières de cette couche isolante, ni sur son utilisation éventuelle pour conduire la chaleur entre la résistance électrique et les soudures. Un substrat (11) électriquement isolant et conducteur de la chaleur porte les bornes principales et la résistance électrique, mais reste à l'écart des soudures, de sorte qu'il n'est pas utilisé pour conduire la chaleur entre la résistance électrique et les soudures.

### EXPOSE DE L'INVENTION

Un problème proposé par la présente invention est de limiter les risques d'endommagement des composants électroniques de type transistor à effet de champ à grille isolée (MOSFET) dans un dispositif électronique de découpage de tension à modulation de largeur permettant de commander un actionneur électrique, par exemple en pilotant la vitesse de rotation d'un moteur électrique. Une application avantageuse est notamment la commande d'un moteur électrique à courant continu servant à la ventilation des échangeurs et du moteur d'un véhicule automobile, pour leur refroidissement.

Simultanément, l'invention vise à limiter efficacement les risques d'incendie pouvant résulter d'une défaillance des composants électroniques de type transistor à effet de champ à grille isolée (MOSFET) dans un tel dispositif électronique de commande pour actionneur électrique.

Pour atteindre ces objets ainsi que d'autres, l'invention propose un dispositif de commande pour un actionneur électrique tel qu'un moteur électrique, comprenant :
- un circuit électronique de puissance, ayant une entrée de puissance destinée à être connectée à une source d'alimentation électrique à courant continu, ayant une sortie de puissance destinée à être connectée à l'actionneur électrique, comprenant un premier transistor à effet de champ à grille isolée dont le circuit source-drain est connecté électriquement d'une part à l'entrée de puissance, et est connecté électriquement d'autre part à la sortie de puissance par un conducteur de sortie pour être en série avec l'actionneur électrique, le circuit électronique de puissance comprenant une diode de roue libre connectée en polarisation inverse sur la sortie de puissance pour permettre la circulation du courant généré par la composante inductive de l'actionneur électrique lorsque le premier transistor à effet de champ à grille isolée est bloqué,
- une commande de commutation, apte à générer sur la grille dudit premier transistor à effet de champ à grille isolée un signal de commande sensiblement carré modulé en largeur,
dans lequel le circuit source-drain du premier transistor à effet de champ à grille isolée est connecté électriquement par des premiers moyens de connexion comprenant une première brasure et une source de chaleur disposées toutes deux sur un même substrat électriquement isolant,
et dans lequel ladite première brasure est agencée de telle sorte que, lorsque la chaleur dégagée par la source de chaleur dépasse un seuil prédéterminé, la première brasure fond et interrompt la connexion électrique assurée par les premiers moyens de connexion ;
selon l'invention :
- les premiers moyens de connexion aptes à interrompre une connexion électrique sont disposés entre le premier transistor à effet de champ à grille isolée et le conducteur de sortie,
- la source de chaleur est le premier transistor à effet de champ à grille isolée lui-même,
- ladite première brasure est agencée de telle sorte que, lorsque la température du corps du premier transistor à effet de champ à grille isolée dépasse un seuil de température prédéterminé, la première brasure fond et interrompt la connexion électrique entre le premier transistor à effet de champ à grille isolée et l'actionneur électrique,
- le premier transistor à effet de champ à grille isolée est de type CMS (composant monté en surface), et est monté par contact de son corps sur ledit substrat,
- la première brasure est disposée en contact avec ledit substrat,
- ledit substrat présente une conductivité thermique supérieure ou égale à 5 W/m.°K.

Le premier transistor à effet de champ à grille isolée étant de type CMS, son corps est en appui intime sur le substrat électriquement isolant pour une bonne transmission de chaleur par conduction, lequel substrat est en un matériau choisi pour être un bon conducteur thermique pour amener de la chaleur dégagée par le premier transistor à effet de champ à grille isolée jusqu'à la première brasure.

En pratique, la première brasure est en contact avec une couche électriquement isolante du substrat par l'intermédiaire d'une première piste conductrice dudit substrat connectée au circuit source-drain du premier transistor à effet de champ à grille isolée, tandis que le corps du premier transistor à effet de champ à grille isolée peut être en contact direct avec ladite couche électriquement isolante, ou en contact avec celle-ci par l'intermédiaire d'une autre piste conductrice dudit substrat.

De la sorte, ledit substrat électriquement isolant constitue des premiers moyens de couplage thermique par conduction entre le premier transistor à effet de champ à grille isolée et la première brasure, favorisant la réactivité de l'interruption du courant électrique lors d'une élévation de température du premier transistor à effet de champ à grille isolée, et permettant de garantir une bonne précision de la température du transistor à effet de champ à grille isolée à partir de laquelle se produira l'interruption du courant électrique.

Lorsque la température du corps du premier transistor à effet de champ à grille isolée dépasse le seuil de température prédéterminé, la chaleur amenée par les premiers moyens de couplage thermique provoque la fusion de la première brasure, laquelle fusion ouvre le circuit électrique et interrompt le passage de courant à travers le premier transistor à effet de champ à grille isolée. Le premier transistor à effet de champ à grille isolée cesse alors de fonctionner avant que sa température ne provoque sa défaillance et/ou un éventuel incendie. Le premier transistor à effet de champ à grille isolée est ainsi préservé, et le risque d'incendie limité.

Avantageusement, on peut prévoir que :
- les premiers moyens de connexion comprennent une première lame, connectée électriquement par la première brasure au circuit source-drain du premier transistor à effet de champ à grille isolée, et connectée électriquement au conducteur de sortie,
- lorsque la première brasure fond, une extrémité libre de la première lame est déplacée, par retour élastique ou par mémoire de forme, à l'écart du circuit source-drain du premier transistor à effet de champ à grille isolée.

L'utilisation d'une lame à retour élastique ou à mémoire de forme permet d'assurer mécaniquement une bonne déconnexion au niveau de la première brasure.

De préférence, lorsque la première lame est connectée par la première brasure, elle peut présenter, entre la première brasure et le conducteur de sortie, un profil longitudinal non rectiligne.

Du fait des variations de température auxquelles est soumis le dispositif de commande, il peut se produire des phénomènes de dilatation et de retrait induisant des variations dimensionnelles de la distance entre le circuit électronique de puissance et le conducteur de sortie. Le profil longitudinal non rectiligne de la lame lui procure une capacité de déformation longitudinale à faible résistance mécanique permettant d'absorber ces variations dimensionnelles sans induire de contraintes mécaniques excessives sur le substrat supportant les composants du dispositif de commande :
- en cas de diminution de la distance entre le circuit électronique de puissance et le conducteur de sortie, la lame se déforme plus à l'écart d'un profil longitudinal rectiligne,
- en cas d'augmentation de la distance entre le circuit électronique de puissance et le conducteur de sortie, la lame se déforme de façon à tendre vers un profil longitudinal plus rectiligne.

Avantageusement, on peut prévoir que ledit substrat comporte une couche en céramique.

La céramique peut être un oxyde d'aluminium (AL₂O₃) ou un nitrure d'aluminium (AIN) par exemple. Le premier transistor à effet de champ à grille isolée étant de type CMS, son corps est en appui intime sur le substrat à couche en céramique pour une bonne transmission de chaleur par conduction à la couche en céramique, laquelle est en un matériau choisi pour être un bon conducteur thermique pour amener de la chaleur dégagée par le premier transistor à effet de champ à grille isolée jusqu'à la première brasure. En pratique, la première brasure est en contact avec la couche en céramique par l'intermédiaire d'une première piste conductrice dudit substrat connectée au circuit source-drain du premier transistor à effet de champ à grille isolée, tandis que le corps du premier transistor à effet de champ à grille isolée peut être en contact direct avec la couche en céramique, ou en contact avec celle-ci par l'intermédiaire d'une autre piste conductrice.

En alternative, on peut prévoir que ledit substrat comprend une couche métallique associée à une couche électriquement isolante. Le matériau de la couche métallique du substrat est également choisi pour être un bon conducteur thermique pour amener de la chaleur dégagée par le premier transistor à effet de champ à grille isolée depuis le corps dudit transistor jusqu'à la première brasure. La couche métallique peut être en aluminium ou en un alliage d'aluminium, ou en cuivre ou en un alliage de cuivre par exemple.

Avantageusement, on peut prévoir que :
- dans le circuit électronique de puissance, la diode de roue libre est constituée par la diode de structure d'un deuxième transistor à effet de champ à grille isolée,
- des moyens de pilotage sont configurés pour mettre à l'état conducteur le deuxième transistor à effet de champ à grille isolée pendant que le premier transistor est à l'état non-conducteur,
- le deuxième transistor à effet de champ à grille isolée est connecté électriquement par des deuxièmes moyens de connexion au conducteur de sortie,
- les deuxièmes moyens de connexion comprennent une deuxième brasure et des deuxièmes moyens de couplage thermique par conduction entre la deuxième brasure et le corps du deuxième transistor à effet de champ à grille isolée,
- ladite deuxième brasure est agencée de telle sorte que, lorsque le corps du deuxième transistor à effet de champ à grille isolée dépasse un seuil de température prédéterminé, la deuxième brasure fond et interrompt la connexion électrique entre le deuxième transistor à effet de champ à grille isolée et l'actionneur électrique.

Le deuxième transistor à effet de champ à grille isolée présente, à l'état conducteur, une résistance résiduelle (rds on) très faible, qui induit des pertes beaucoup plus faibles que la tension de jonction d'une diode de roue libre « standard » à l'état conducteur. De la sorte, la mise en conduction du deuxième transistor à effet de champ à grille isolée permet de limiter les pertes pendant la phase de passage du courant de roue libre. Toutefois, il faut également veiller à ce que le deuxième transistor à effet de champ à grille isolée ne s'échauffe pas lui-même au-delà d'une limite pouvant provoquer sa défaillance, voire un début d'incendie. En effet, en cas de défaillance du deuxième transistor à effet de champ à grille isolée, celui-ci peut rester bloqué à l'état conducteur : lorsque le premier transistor à effet de champ à grille isolée passera à l'état conducteur, la source d'alimentation électrique à courant continu sera mise en court-circuit. Dans le cas d'un véhicule automobile, cela met hors d'usage la batterie du véhicule. Il y a donc un fort intérêt à limiter le risque de défaillance du deuxième transistor à effet de champ à grille isolée.

Pour ce faire, lorsque la température du corps du deuxième transistor à effet de champ à grille isolée dépasse le seuil de température prédéterminé, la chaleur amenée par les deuxièmes moyens de couplage thermique provoque la fusion de la deuxième brasure, laquelle fusion ouvre le circuit électrique et interrompt le passage de courant à travers le deuxième transistor à effet de champ à grille isolée. Le deuxième transistor à effet de champ à grille isolée cesse alors de fonctionner avant que sa température ne provoque sa défaillance et/ou un éventuel incendie. Le deuxième transistor à effet de champ à grille isolée est ainsi préservé, et le risque d'incendie limité.

Pour des raisons similaires à celles exprimées précédemment en lien avec le premier transistor à effet de champ à grille isolée, on peut en outre prévoir que :
- les moyens de connexion comprennent une deuxième lame connectée électriquement par la deuxième brasure au circuit source-drain du deuxième transistor à effet de champ à grille isolée et connectée électriquement au conducteur de sortie,
- lorsque la deuxième brasure fond, une extrémité libre de la deuxième lame est déplacée, par retour élastique ou par mémoire de forme, à l'écart du circuit source-drain du deuxième transistor à effet de champ à grille isolée.

Pour des raisons similaires à celles exprimées précédemment en lien avec le premier transistor à effet de champ à grille isolée, on peut en outre prévoir que, lorsque la deuxième lame est connectée par la deuxième brasure, elle présente, entre la deuxième brasure et le conducteur de sortie, un profil longitudinal non rectiligne.

Pour des raisons similaires à celles exprimées précédemment en lien avec le premier transistor à effet de champ à grille isolée, on peut en outre prévoir que :
- le deuxième transistor à effet de champ à grille isolée est de type CMS (composant monté en surface), monté par contact de son corps sur un substrat présentant une conductivité thermique supérieure ou égale à 5 W/m.°K,
- la deuxième brasure est disposée en contact avec le substrat.

Pour des raisons similaires à celles exprimées précédemment en lien avec le premier transistor à effet de champ à grille isolée, on peut en outre prévoir que :
- le deuxième transistor à effet de champ à grille isolée est de type CMS (composant monté en surface), monté par contact de son corps sur un substrat comportant une couche en céramique,
- la deuxième brasure est disposée en contact avec le substrat comportant une couche en céramique.

En alternative, on peut prévoir que :
- le deuxième transistor à effet de champ à grille isolée est de type CMS (composant monté en surface), monté par contact de son corps sur un substrat comprenant une couche métallique associée à une couche électriquement isolante,
- la deuxième brasure est disposée en contact avec le substrat comprenant une couche métallique associée à une couche électriquement isolante.

### DESCRIPTION SOMMAIRE DES DESSINS

D'autres objets, caractéristiques et avantages de la présente invention ressortiront de la description suivante de modes de réalisation particuliers, faite en relation avec les figures jointes, parmi lesquelles :
[Fig.1] La figure 1 est une représentation schématique du circuit électrique d'un premier mode de réalisation de dispositif de commande pour actionneur électrique selon l'invention ;
[Fig.2] La figure 2 est une vue schématique de côté d'un mode de réalisation particulier des premiers moyens de connexion du dispositif de commande de la figure 1 au conducteur de sortie, à l'état fermé ;
[Fig.3] La figure 3 est une autre vue schématique de côté des premiers moyens de connexion de la figure 2, à l'état ouvert.
[Fig.4] La figure 4 est une vue schématique de côté d'un mode de réalisation particulier des deuxièmes moyens de connexion du dispositif de commande de la figure 1 au conducteur de sortie, à l'état fermé ;
[Fig.5] La figure 5 est une autre vue schématique de côté des deuxièmes moyens de connexion de la figure 4, à l'état ouvert ; et
[Fig.6] La figure 6 est une représentation schématique du circuit électrique d'un deuxième mode de réalisation de dispositif de commande pour actionneur électrique selon l'invention.

### DESCRIPTION DES MODES DE REALISATION PREFERES

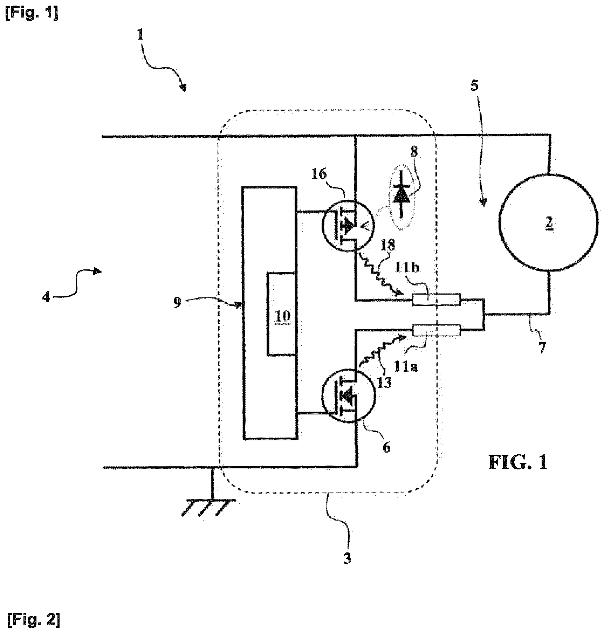

Sur la figure 1 est illustré schématiquement le circuit électrique d'un mode de réalisation particulier de dispositif de commande 1 pour actionneur électrique 2 selon l'invention. L'actionneur électrique 2 est ici un moteur électrique, mais cela n'est nullement limitatif de la présente invention.

Le dispositif de commande 1 comprend un circuit électronique de puissance 3, ayant une entrée de puissance 4 destinée à être connectée à une source d'alimentation électrique à courant continu, et ayant une sortie de puissance 5 destinée à être connectée au moteur électrique 2. En l'espèce, le moteur électrique 2 à courant continu sert à la ventilation des échangeurs et du moteur d'un véhicule automobile, pour leur refroidissement. La source d'alimentation électrique à courant continu est ainsi constituée par la batterie du véhicule.

Le circuit électronique de puissance 3 comprend un premier transistor 6 à effet de champ à grille isolée dont le circuit source-drain est connecté d'une part à l'entrée de puissance 4, et est connecté d'autre part à la sortie de puissance 5 par un conducteur de sortie 7 pour être en série avec le moteur électrique 2. Le circuit électronique de puissance 3 comprend une diode de roue libre 8 connectée en polarisation inverse sur la sortie de puissance 5. La diode de roue libre 8 permet la circulation du courant généré par la composante inductive du moteur électrique 2 lorsque le premier transistor 6 à effet de champ à grille isolée est bloqué (c'est-à-dire est à l'état non-conducteur).

La commande du premier transistor 6 à effet de champ à grille isolée permet un découpage de tension à modulation de largeur, généralement désigné par le sigle PWM (pulse width modulation - modulateur de largeur d'impulsion), produisant une tension de sortie aux bornes du moteur électrique 2 qui est tantôt égale à la tension d'entrée pendant les étapes de conduction du premier transistor 6 à effet de champ à grille isolée, tantôt sensiblement égale à zéro pendant les étapes de non-conduction du premier transistor 6 à effet de champ à grille isolée, et dont on fait varier la valeur moyenne par la modification du rapport des durées des étapes de conduction et des étapes de non-conduction du premier transistor 6 à effet de champ à grille isolée. On pilote ainsi la vitesse du moteur électrique 2 pour l'adapter progressivement aux besoins en refroidissement du véhicule.

Dans le mode de réalisation illustré sur la figure 1, la diode de roue libre 8 est en fait constituée par la diode de structure d'un deuxième transistor 16 à effet de champ à grille isolée.

Le dispositif de commande 1 comprend une commande de commutation 9 à microcontrôleur 10, apte à générer sur la grille dudit premier transistor 6 à effet de champ à grille isolée un signal de commande sensiblement carré modulé en largeur.

Le microcontrôleur 10 constitue également des moyens de pilotage configurés pour mettre à l'état conducteur le deuxième transistor 16 à effet de champ à grille isolée pendant une partie des étapes de non-conduction du premier transistor 6.

Le premier transistor 6 à effet de champ à grille isolée est connecté électriquement au conducteur de sortie 7 par des premiers moyens de connexion 11a.

Le deuxième transistor 16 à effet de champ à grille isolée est connecté électriquement au conducteur de sortie 7 par des deuxièmes moyens de connexion 11b.

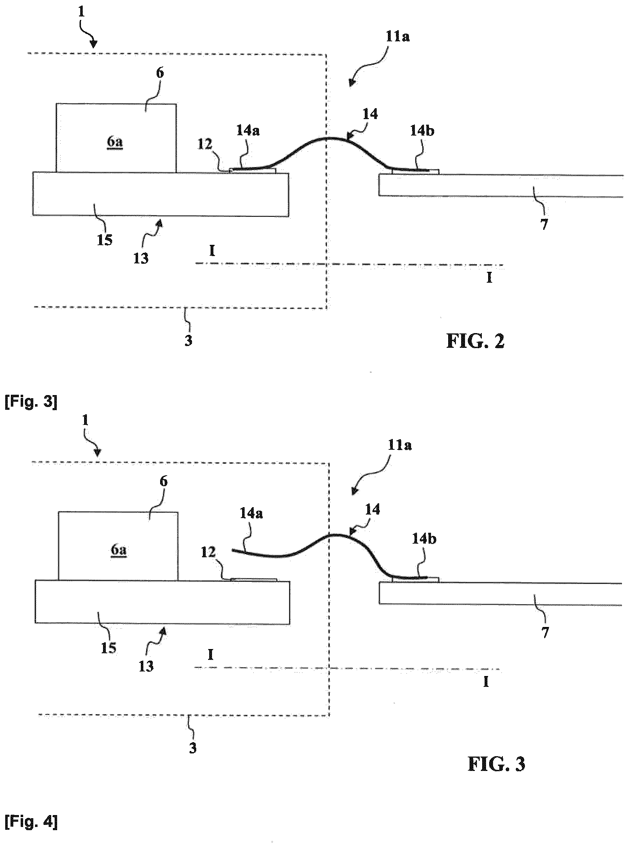

Les premiers moyens de connexion 11a sont plus particulièrement détaillés sur la figure 2 en ce qui concerne le premier transistor 6 à effet de champ à grille isolée, et comprennent dans ce cas une première brasure 12 et des premiers moyens de couplage thermique par conduction 13 entre la première brasure 12 et le corps 6a du premier transistor 6 à effet de champ à grille isolée. En pratique, les premiers moyens de couplage thermique par conduction 13 sont formés par un substrat 15 électriquement isolant et présentant une bonne capacité de conduction thermique. La première brasure 12 est en contact avec une couche électriquement isolante dudit substrat 15 par l'intermédiaire d'une première piste conductrice (non illustrée sur la figure) dudit substrat 15 connectée au circuit source-drain du premier transistor 6 à effet de champ à grille isolée. Le corps 6a du premier transistor 6 à effet de champ à grille isolée, de type CMS, peut être en contact direct avec ladite couche électriquement isolante, ou en contact avec celle-ci par l'intermédiaire d'une autre piste conductrice dudit substrat 15. La première brasure 12 est agencée et structurée de telle sorte que, lorsque la température du corps 6a du premier transistor 6 à effet de champ à grille isolée dépasse un seuil de température prédéterminé, la première brasure 12 fond et interrompt la connexion électrique entre le premier transistor 6 à effet de champ à grille isolée et le conducteur de sortie 7 (et interrompt donc la connexion électrique entre le premier transistor 6 à effet de champ à grille isolée et le moteur électrique 2). Par exemple, la première brasure 12 peut être une brasure à l'alliage d'étain sans plomb, dont la fusion intervient à une température d'environ 210 °C.

De façon avantageuse, les premiers moyens de connexion 11a peuvent comprendre une première lame 14, connectée électriquement par la première brasure 12 au circuit source-drain du premier transistor 6 à effet de champ à grille isolée, et connectée électriquement au conducteur de sortie 7. De façon plus précise, la première lame 14 s'étend entre une première extrémité 14a en prise dans la première brasure 12 et une deuxième extrémité 14b connectée électriquement au conducteur de sortie 7. En pratique, la connexion électrique de la deuxième extrémité 14b au conducteur de sortie 7 peut par exemple être effectuée par une connexion apte à ne pas se déconnecter dans les conditions de rupture de la première brasure 12. On peut par exemple recourir à une brasure en un métal ayant une température de fusion plus haute que celle du métal utilisé dans la première brasure 12. On peut également recourir à une soudure électrique ou par laser.

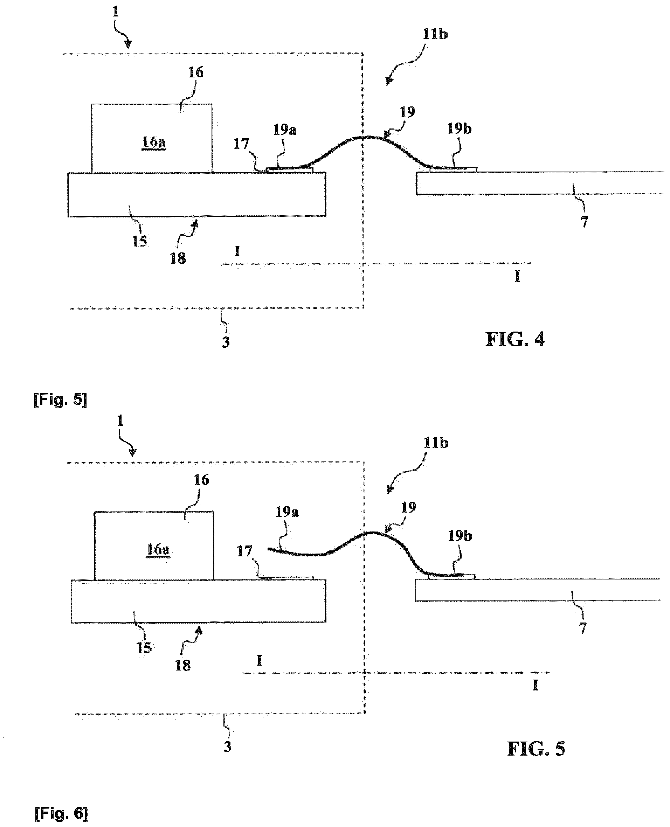

Les deuxièmes moyens de connexion 11b sont plus particulièrement détaillés sur la figure 4 en ce qui concerne le deuxième transistor 16 à effet de champ à grille isolée, et comprennent dans ce cas une deuxième brasure 17 et des deuxièmes moyens de couplage thermique par conduction 18 entre la deuxième brasure 17 et le corps 16a du deuxième transistor 16 à effet de champ à grille isolée. La deuxième brasure 17 est agencée et structurée de telle sorte que, lorsque la température du corps 16a du deuxième transistor 16 à effet de champ à grille isolée dépasse un seuil de température prédéterminé, la deuxième brasure 17 fond et interrompt la connexion électrique entre le deuxième transistor 16 à effet de champ à grille isolée et le conducteur de sortie 7 (et interrompt donc la connexion électrique entre le deuxième transistor 16 à effet de champ à grille isolée et le moteur électrique 2). Par exemple, la deuxième brasure 17 peut être une brasure à l'alliage d'étain sans plomb, dont la fusion intervient à une température d'environ 210 °C.

De façon avantageuse, les deuxièmes moyens de connexion 11b peuvent comprendre une deuxième lame 19 à mémoire de forme connectée électriquement par la deuxième brasure 17 au circuit source-drain du deuxième transistor 16 à effet de champ à grille isolée et connectée électriquement au conducteur de sortie 7. De façon plus précise, la deuxième lame 19 à mémoire de forme s'étend entre une première extrémité 19a en prise dans la deuxième brasure 17 et une deuxième extrémité 19b connectée électriquement au conducteur de sortie 7. En pratique, la connexion électrique de la deuxième extrémité 19b au conducteur de sortie 7 peut par exemple être effectuée par une connexion apte à ne pas se déconnecter dans les conditions de rupture de la deuxième brasure 17. On peut par exemple recourir à une brasure en un métal ayant une température de fusion plus haute que celle du métal utilisé dans la première brasure 12. On peut également recourir à une soudure électrique ou par laser.

En cas d'élévation de la température du corps 6a du premier transistor 6 à effet de champ à grille isolée au-delà du seuil prédéterminé, la première brasure 12 fond, et la première extrémité libre 14a de la première lame 14 est déplacée, par retour élastique ou par mémoire de forme de la première lame 14, à l'écart de la première brasure 12 (et donc à l'écart du circuit source-drain du premier transistor 6 à effet de champ à grille isolée), comme illustré sur la figure 3. Respectivement, en cas d'élévation de la température du corps 16a du deuxième transistor 16 à effet de champ à grille isolée au-delà du seuil prédéterminé, la deuxième brasure 17 fond, et la première extrémité libre 19a de la deuxième lame 19 est déplacée, par retour élastique ou par mémoire de forme de la deuxième lame 19, à l'écart de la deuxième brasure 17 (et donc à l'écart du circuit source-drain du deuxième transistor 16 à effet de champ à grille isolée), comme illustré sur la figure 5.

On remarque que, lorsque les première 14 et deuxième 19 lames sont connectées respectivement aux première 12 et deuxième 17 brasures (figures 2 et 4), elles présentent, entre la première 12 ou deuxième 17 brasure et le conducteur de sortie 7, un profil longitudinal (selon la direction longitudinale l-l) non rectiligne. En l'espèce, les première 14 et deuxième 19 lames ont une forme courbe.

Une telle forme des première 14 et deuxième 19 lames permet :
- une déformation encore plus importante des première 14 et deuxième 19 lames en cas de diminution de la distance entre le circuit électronique de puissance 3 et le conducteur de sortie 7, tendant alors à augmenter le caractère non rectiligne du profil longitudinal des lames 14 et 19,
- une atténuation du caractère non rectiligne du profil longitudinal des lames 14 et 19 en cas d'augmentation de la distance entre le circuit électronique de puissance 3 et le conducteur de sortie 7, les lames 14 et 19 se déformant alors de façon à tendre vers un profil longitudinal plus rectiligne.

Sur les figures 2 et 3 on voit que, pour assurer un couplage thermique efficace entre la première brasure 12 et le premier transistor 6 à effet de champ à grille isolée, les premiers moyens de couplage thermique par conduction 13 comprennent un substrat 15 comportant une couche en une céramique ayant une grande conductivité thermique, et sur lequel le corps 6a du premier transistor 6 à effet de champ à grille isolée est apposé (le premier transistor 6 à effet de champ à grille isolée est de type CMS - composant monté en surface), et la première brasure 12 est en contact avec une piste conductrice du substrat 15 comportant une couche en céramique. La conductivité thermique intrinsèque relativement bonne de la céramique ainsi choisie assure un bon couplage thermique entre le boîtier 6a du premier transistor 6 à effet de champ à grille isolée et la première brasure 12.

De façon similaire, on voit sur les figures 4 et 5 que, pour assurer un couplage thermique efficace entre la deuxième brasure 17 et le deuxième transistor 16 à effet de champ à grille isolée, les deuxièmes moyens de couplage thermique par conduction 18 comprennent un substrat 15 comportant une couche en une céramique à grande conductivité thermique, et sur lequel le corps 16a du deuxième transistor 16 à effet de champ à grille isolée est apposé (le deuxième transistor 16 à effet de champ à grille isolée est de type CMS - composant monté en surface), et la deuxième brasure 17 est en contact avec une piste conductrice du substrat 15 comportant une couche en céramique.

Parmi les céramiques à bonne conductivité thermique, on pourra par exemple choisir, pour réaliser la couche en céramique du substrat 15 supportant les transistors 6 et 16 à effet de champ à grille isolée : un oxyde d'aluminium (AL₂O₃), permettant d'obtenir un substrat 15 dont la conductivité thermique est de l'ordre de 30 W/m.°K, ou un nitrure d'aluminium (AIN), permettant d'obtenir un substrat 15 dont la conductivité thermique est de l'ordre de 200 W/m.°K.

En alternative à un substrat 15 comportant une couche en céramique, on peut recourir à un substrat 15 comprenant une couche métallique associée à une couche électriquement isolante. La couche électriquement isolante peut être formée par un diélectrique thermiquement conducteur.

La couche métallique est en un métal ou alliage de métal ayant une grande conductivité thermique. On pourra par exemple choisir, pour réaliser la couche métallique du substrat 15 supportant les transistors 6 et 16 à effet de champ à grille isolée : de l'aluminium dont la conductivité thermique est de l'ordre de 30 W/m.°K, ou du cuivre dont la conductivité thermique est de l'ordre de 200 W/m.°K. Ladite couche métallique est recouverte d'une couche diélectrique thermiquement conductrice dont la conductivité thermique est de l'ordre de 8 W/m.°K. Par comparaison, un substrat en époxy renforcé par de la fibre de verre présente généralement une conductivité thermique de l'ordre de 0,8 W/m.°K.

Dans tous les cas, pour assurer un couplage thermique efficace entre la première brasure 12 (respectivement la deuxième brasure 17) et le premier transistor 6 (respectivement le deuxième transistor 16) à effet de champ à grille isolée de type CMS, les premiers moyens de couplage thermique par conduction 13 (respectivement les deuxièmes moyens de couplage thermique par conduction 18) comprennent un substrat 15 présentant une conductivité thermique supérieure ou égale à 5 W/m.°K. La première brasure 12 (respectivement la deuxième brasure 17) est disposée en contact avec le substrat 15.

Dans le premier mode de réalisation illustré sur la figure 1, le premier transistor 6 à effet de champ à grille isolée est le plus sollicité en fonctionnement, car il est traversé par le courant à pleine charge. Ce premier mode de réalisation permet d'utiliser, en guise de premier transistor 6, un MOSFET de type N. Cela s'avère particulièrement avantageux en termes de coûts : à résistance interne équivalente, un MOSFET de type N est nettement moins coûteux qu'un MOSFET de type P.

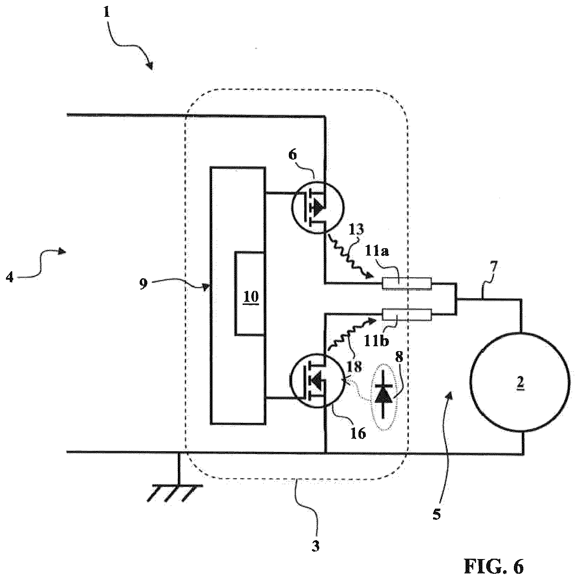

Un deuxième mode de réalisation est illustré sur la figure 6, lequel est très similaire au premier mode de réalisation : les éléments qui y sont identifiés par des références numériques identiques à celles utilisées dans le cadre du premier mode de réalisation désignent des éléments identiques à ceux décrits dans le cadre du premier mode de réalisation.

Ce deuxième mode de réalisation diffère du premier en ce que l'actionneur électrique (moteur) 2 est connecté entre le conducteur de sortie 7 et la masse.

Ce deuxième mode de réalisation est moins avantageux en termes de coûts : le premier transistor 6 à effet de champ à grille isolée dont le circuit source-drain, qui est connecté d'une part à l'entrée de puissance 4 et d'autre part à la sortie de puissance 5 par le conducteur de sortie 7 pour être en série avec l'actionneur électrique 2, est cette fois un MOSFET de type P, donc plus onéreux à résistance interne équivalente. Ce deuxième mode de réalisation est toutefois plus avantageux que le premier mode de réalisation en termes de compatibilité électromagnétique, du fait de la disposition de l'actionneur électrique (moteur) 2 entre le conducteur de sortie 7 et la masse, et du fait que la plupart des actionneurs électriques de type moteur ont ainsi leur carcasse connectée électriquement à la masse.

Dans les deux modes de réalisation qui ont été explicitement décrits, la diode de roue libre 8 est constituée par la diode de structure du deuxième transistor 16 à effet de champ à grille isolée. Ces deux modes de réalisation permettent de réduire les pertes d'énergie électrique générées pendant le fonctionnement en roue libre, grâce à la faible résistance interne du deuxième transistor à effet de champ à grille isolée dans son état passant. Cependant, dans certaines applications, en particulier si les conditions d'utilisation (température ambiante, intensité du courant électrique dans l'actionneur électrique) le permettent, on pourra trouver avantage, sans sortir du cadre de la présente invention, à utiliser comme diode de roue libre 8 une simple diode de puissance, qui est un composant moins onéreux qu'un transistor à effet de champ à grille isolée.

La présente invention n'est pas limitée aux modes de réalisation qui ont été explicitement décrits, mais elle en inclut les diverses variantes et généralisations contenues dans le domaine des revendications ci-après.

## Revendications

1. Dispositif de commande (1) pour un actionneur électrique (2) tel qu'un moteur, comprenant :
- un circuit électronique de puissance (3), ayant une entrée de puissance (4) destinée à être connectée à une source d'alimentation électrique à courant continu, ayant une sortie de puissance (5) destinée à être connectée à l'actionneur électrique (2), comprenant un premier transistor (6) à effet de champ à grille isolée dont le circuit source-drain est connecté électriquement d'une part à l'entrée de puissance (4), et est connecté électriquement d'autre part à la sortie de puissance (5) par un conducteur de sortie (7) pour être en série avec l'actionneur électrique (2), le circuit électronique de puissance (3) comprenant une diode de roue libre (8) connectée en polarisation inverse sur la sortie de puissance (5) pour permettre la circulation du courant généré par la composante inductive de l'actionneur électrique (2) lorsque le premier transistor (6) à effet de champ à grille isolée est bloqué,
- une commande de commutation (9), apte à générer sur la grille dudit premier transistor (6) à effet de champ à grille isolée un signal de commande sensiblement carré modulé en largeur,
dans lequel le circuit source-drain du premier transistor (6) à effet de champ à grille isolée est connecté électriquement par des premiers moyens de connexion (11a) comprenant une première brasure (12) et une source de chaleur (6) disposées toutes deux sur un même substrat électriquement isolant (15),
et dans lequel ladite première brasure (12) est agencée de telle sorte que, lorsque la chaleur dégagée par ladite source de chaleur (6) dépasse un seuil prédéterminé, la première brasure (12) fond et interrompt la connexion électrique assurée par les premiers moyens de connexion,
**caractérisé en ce que** :
- les premiers moyens de connexion (11a) aptes à interrompre une connexion électrique sont disposés entre le premier transistor (6) à effet de champ à grille isolée et le conducteur de sortie (7),
- ladite source de chaleur est le premier transistor (6) à effet de champ à grille isolée lui-même,
- ladite première brasure (12) est agencée de telle sorte que, lorsque la température du corps (6a) du premier transistor (6) à effet de champ à grille isolée dépasse un seuil de température prédéterminé, la première brasure (12) fond et interrompt la connexion électrique entre le premier transistor (6) à effet de champ à grille isolée et l'actionneur électrique (2),
- le premier transistor (6) à effet de champ à grille isolée est de type CMS (composant monté en surface), et est monté par contact de son corps (6a) sur ledit substrat (15),
- la première brasure (12) est disposée en contact avec ledit substrat (15),
- ledit substrat présente une conductivité thermique supérieure ou égale à 5 W/m.°K.

2. Dispositif de commande (1) selon la revendication 1,
**caractérisé en ce que** :
- les premiers moyens de connexion (11a) comprennent une première lame (14), connectée électriquement par la première brasure (12) au circuit source-drain du premier transistor (6) à effet de champ à grille isolée, et connectée électriquement au conducteur de sortie (7),
- lorsque la première brasure (12) fond, une extrémité libre (14a) de la première lame (14) est déplacée, par retour élastique ou par mémoire de forme, à l'écart du circuit source-drain du premier transistor (6) à effet de champ à grille isolée.

3. Dispositif de commande (1) selon la revendication 2, **caractérisé en ce que**, lorsque la première lame (14) est connectée par la première brasure (12), elle présente, entre la première brasure (12) et le conducteur de sortie (7), un profil longitudinal non rectiligne.

4. Dispositif de commande (1) selon l'une quelconque des revendications 1 à 3, **caractérisé en ce que** ledit substrat (15) comporte une couche en céramique.

5. Dispositif de commande (1) selon l'une quelconque des revendications 1 à 3, **caractérisé en ce que** le substrat (15) comprend une couche métallique associée à une couche électriquement isolante.

6. Dispositif de commande (1) selon l'une quelconque des revendications 1 à 5, **caractérisé en ce que** :
- dans le circuit électronique de puissance (3), la diode de roue libre (8) est constituée par la diode de structure d'un deuxième transistor (16) à effet de champ à grille isolée,
- des moyens de pilotage sont configurés pour mettre à l'état conducteur le deuxième transistor (16) à effet de champ à grille isolée pendant que le premier transistor (6) est à l'état non-conducteur,
- le circuit source-drain du deuxième transistor (16) à effet de champ à grille isolée est connecté électriquement par des deuxièmes moyens de connexion (11b) au conducteur de sortie (7),
- les deuxièmes moyens de connexion (11b) comprennent une deuxième brasure (17) et des deuxièmes moyens de couplage thermique par conduction (18) entre la deuxième brasure (17) et le corps (16a) du deuxième transistor (16) à effet de champ à grille isolée,
- ladite deuxième brasure (17) est agencée de telle sorte que, lorsque la température du corps (16a) du deuxième transistor (16) à effet de champ à grille isolée dépasse un seuil de température prédéterminé, la deuxième brasure (17) fond et interrompt la connexion électrique entre le deuxième transistor (16) à effet de champ à grille isolée et l'actionneur électrique (2).

7. Dispositif de commande (1) selon la revendication 6,
**caractérisé en ce que** :
- les deuxièmes moyens de connexion (11b) comprennent une deuxième lame (19), connectée électriquement par la deuxième brasure (17) au circuit source-drain du deuxième transistor (16) à effet de champ à grille isolée, et connectée électriquement au conducteur de sortie (7),
- lorsque la deuxième brasure (17) fond, une extrémité libre (19a) de la deuxième lame (19) est déplacée, par retour élastique ou par mémoire de forme, à l'écart du circuit source-drain du deuxième transistor (16) à effet de champ à grille isolée.

8. Dispositif de commande (1) selon la revendication 7, **caractérisé en ce que**, lorsque la deuxième lame (19) est connectée par la deuxième brasure (17), elle présente, entre la deuxième brasure (17) et le conducteur de sortie (7), un profil longitudinal non rectiligne.

9. Dispositif de commande (1) selon l'une quelconque des revendications 6 à 8, **caractérisé en ce que** :
- le deuxième transistor (16) à effet de champ à grille isolée est de type CMS (composant monté en surface), monté par contact de son corps (16a) sur un substrat (15) présentant une conductivité thermique supérieure ou égale à 5 W/m.°K,
- la deuxième brasure (17) est disposée en contact avec le substrat (15).

10. Dispositif de commande (1) selon l'une quelconque des revendications 6 à 9, **caractérisé en ce que** :
- le deuxième transistor (16) à effet de champ à grille isolée est de type CMS (composant monté en surface), monté par contact de son corps (16a) sur un substrat (15) comportant une couche en céramique,
- la deuxième brasure (17) est disposée en contact avec le substrat (15) comportant une couche en céramique.

11. Dispositif de commande (1) selon l'une quelconque des revendications 6 à 9, **caractérisé en ce que** :
- le deuxième transistor (16) à effet de champ à grille isolée est de type CMS (composant monté en surface), monté par contact de son corps (16a) sur un substrat (15) comprenant une couche métallique associée à une couche électriquement isolante,
- la deuxième brasure (17) est disposée en contact avec le substrat (15) comprenant une couche métallique associée à une couche électriquement isolante. j
